# EUROPEAN PATENT APPLICATION

(11) **EP 4 790 103 A1**
(43) Date of publication of application: **12.08.2026**
(21) Application number: 24874751.1
(22) Date of filing: 04.10.2024
(51) Int. Cl.: C08L 83/07, C08L 83/05, H01L 23/29, H01L 23/31

(54) **HEAT-RESISTANT SILICONE GEL-FORMING COMPOSITION AND USE OF SAME**

(30) Priority: 05.10.2023 JP 2023173755
(71) Applicant: Dow Toray Co., Ltd., Tokyo 140-8617 (JP)
(72) Inventor: FUJISAWA Toyohiko, Ichihara-shi, Chiba 299-0108 (JP); OTA Kenji, Ichihara-shi, Chiba 299-0108 (JP)
(74) Representative: Elkington and Fife LLP
(86) International application number: PCT/JP2024/035630
(87) International publication number: WO 2025/075151

(57) **Abstract**

To provide: a novel silicone gel-forming composition having excellent heat resistance; and the like. A silicone gel-forming composition containing the following components (A) to (E): (A) an organopolysiloxane having, on average, two or more alkenyl groups bonded to a silicon atom in one molecule; (B) an organohydrogenpolysiloxane having two or more hydrogen atoms bonded to silicon atoms in one molecule; (C) an organosiloxane compound having one hydrogen atom bonded to a silicon atom in one molecule (excluding compounds having an alkoxysilyl group); (D) a hydrosilylation reaction catalyst; and (E) a heat-resistant additive, wherein the molar ratio of silicon atom-bonded hydrogen atoms in components (B) and (C) to alkenyl groups in component (A) is 0.80 or greater.

## Description

### TECHNICAL FIELD

The present invention relates to: a heat-resistant silicone gel-forming composition; an electronic component sealant containing the composition; a silicone gel obtained by curing the composition or the electronic component sealant; an electronic component containing the silicone gel; and a method for manufacturing the electronic component.

### BACKGROUND ART

A known type of curable organopolysiloxane composition is a composition that can form a silicone gel upon curing (silicone gel-forming composition). Such silicone gel-forming composition is widely used as a sealing material or sealant for electrical and electronic devices and the like (e.g., Patent Documents 1 to 3). The silicone gel obtained from the silicone gel-forming composition is required to have heat resistance so as to be able to stably maintain a gel even when exposed to high temperatures, for example, exceeding 210°C, due to use environment and properties of the electrical and electronic devices and the like to which the silicone gel is applied.

### RELATED ART DOCUMENTS

### Patent Documents

Patent Document 1: Japanese PCT Application 2022-545162
Patent Document 2: International Patent Application Publication WO 2022/013917
Patent Document 3: International Patent Application Publication WO 2015/034029

### SUMMARY OF THE INVENTION

### PROBLEM TO BE SOLVED BY THE INVENTION

The present invention provides: a novel silicone gel-forming composition having excellent heat resistance; and the like.

### MEANS FOR SOLVING THE PROBLEM

The present invention provides the following silicone gel-forming composition and the like.
[1] A silicone gel-forming composition containing the following components (A) to (E):
   (A) an organopolysiloxane having, on average, two or more alkenyl groups bonded to a silicon atom in one molecule;
   (B) an organohydrogenpolysiloxane having two or more hydrogen atoms bonded to silicon atoms in one molecule;
   (C) an organosiloxane compound having one hydrogen atom bonded to a silicon atom in one molecule (excluding compounds having an alkoxysilyl group);
   (D) a hydrosilylation reaction catalyst; and
   (E) a heat-resistant additive, wherein
   the molar ratio of silicon atom-bonded hydrogen atoms in components (B) and (C) to alkenyl groups in component (A) is 0.80 or greater.
[2] The silicone gel-forming composition according to [1], wherein the molar ratio of silicon atom-bonded hydrogen atoms in component (B) to alkenyl groups in component (A) is 0.10 or greater.
[3] The silicone gel-forming composition according to [1] or [2], wherein component (C) contains at least one selected from the group consisting of compounds expressed by the following general formulas (1) to (7). 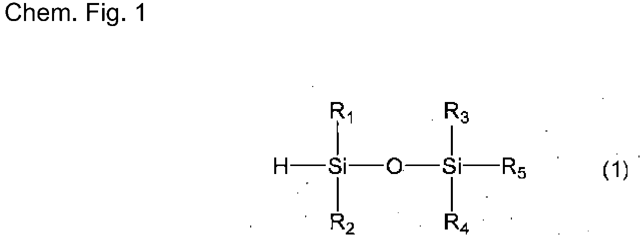 (In formula (1), R₁ to R₅ are each independently the same or different monovalent hydrocarbon groups with 1 to 12 carbon atoms and no aliphatic unsaturated bonds.) 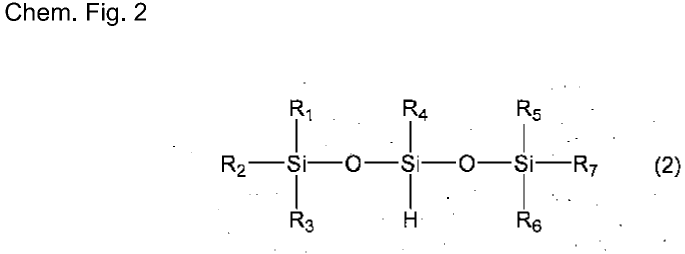 (In formula (2), R₁ to R₃ and R₅ to R₇ are each independently the same or different monovalent hydrocarbon groups with 1 to 12 carbon atoms and no aliphatic unsaturated bonds, and R₄ is a group selected from: monovalent hydrocarbon groups with 1 to 12 carbon atoms and no aliphatic unsaturated bonds; and trimethylsiloxy groups.) 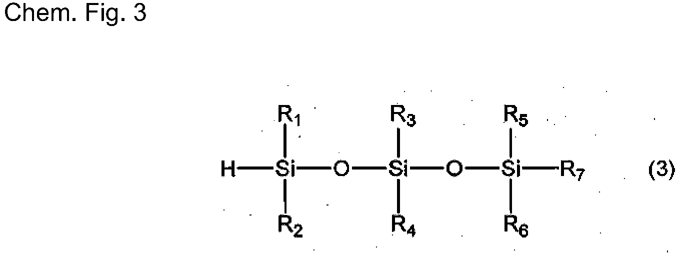 (In formula (3), R₁, R₂, and R₅ to R₇ are each independently the same or different monovalent hydrocarbon groups with 1 to 12 carbon atoms and no aliphatic unsaturated bonds, and R₃ and R₄ are each independently a group selected from the group consisting of the same or different monovalent hydrocarbon groups with 1 to 12 carbon atoms and no aliphatic unsaturated bonds; and trimethylsiloxy groups.) 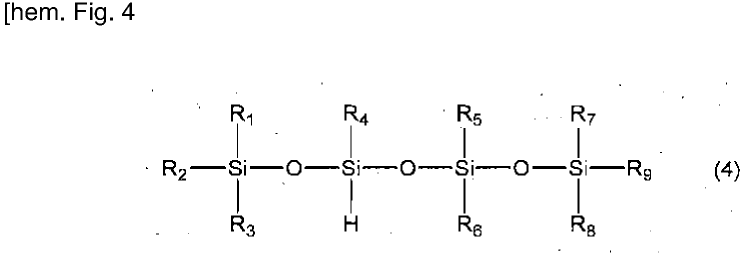 (In formula (4), R₁ to R₃ and R₇ to R₉ are each independently the same or different monovalent hydrocarbon groups with 1 to 12 carbon atoms and no aliphatic unsaturated bonds, and R₄ to R₆ are each independently a group selected from the group consisting of the same or different monovalent hydrocarbon groups with 1 to 12 carbon atoms and no aliphatic unsaturated bonds; and trimethylsiloxy groups.) 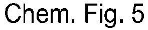 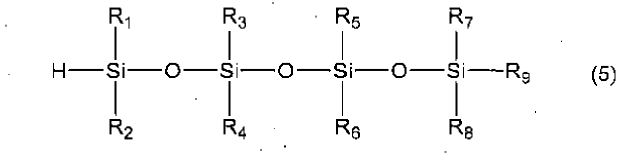 (In formula (5), R₁, R₂, and R₇ to R₉ are each independently the same or different monovalent hydrocarbon groups with 1 to 12 carbon atoms and no aliphatic unsaturated bonds, and R₃ to R₆ are each independently a group selected from the group consisting of the same or different monovalent hydrocarbon groups with 1 to 12 carbon atoms and no aliphatic unsaturated bonds; and trimethylsiloxy groups.) 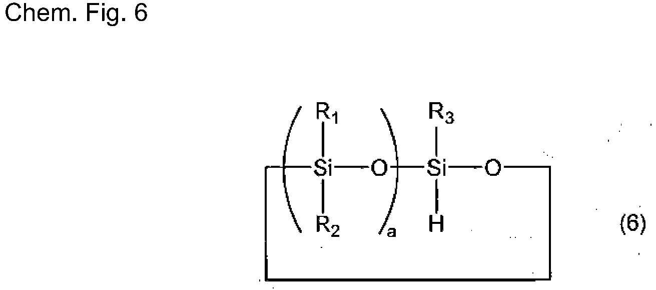 (In formula (6), R₁ and R₂ are each independently the same or different monovalent hydrocarbon groups with 1 to 12 carbon atoms and no aliphatic unsaturated bonds, and R₃ is a group selected from: the same or different monovalent hydrocarbon groups with 1 to 12 carbon atoms and no aliphatic unsaturated bonds; and trimethylsiloxy groups. a is an integer of 2 to 5.) 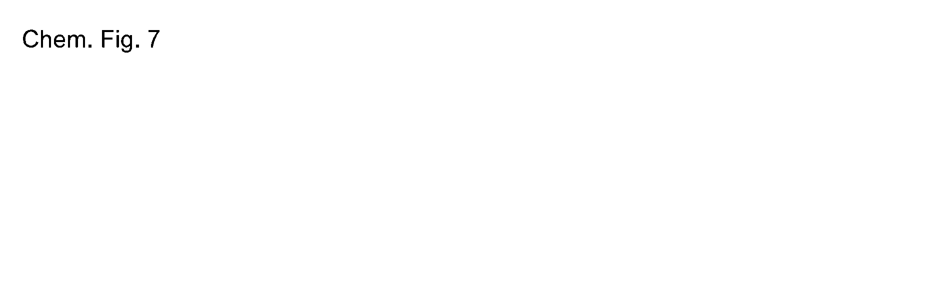 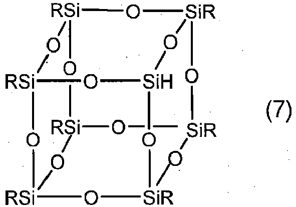 (In formula (7), each R is independently the same or different monovalent hydrocarbon group with 1 to 12 carbon atoms and no aliphatic unsaturated bonds.)
[4] The silicone gel-forming composition according to any one of [1] to [3], wherein the viscosity of component (A) at 25°C is 10 to 10,000 mPa·s, and the viscosity of component (B) at 25°C is 2 to 1,000 mPa·s.
[5] The silicone gel-forming composition according to any one of [1] to [4], wherein component (A) is at least one selected from the group consisting of linear organopolysiloxanes, branched organopolysiloxanes, and mixtures thereof.
[6] The silicone gel-forming composition according to any one of [1] to [5], wherein the amount of component (D) is 0.01 to 1,000 ppm by mass based on the total amount of the silicone gel-forming composition.
[7] The silicone gel-forming composition according to any one of [1] to [6], wherein component (E) contains at least one selected from the group consisting of metal silanolates and metal carboxylates.
[8] The silicone gel-forming composition according to [7], wherein the metal is selected from the group consisting of cerium, iron, manganese, vanadium, magnesium, aluminum, nickel, titanium, and zinc.
[9] The silicone gel-forming composition according to any one of [1] to [8], which is substantially transparent.
[10] The silicone gel-forming composition according to any one of [1] to [9], for use in sealing an electronic component.
[11] The silicone gel-forming composition according to [10], wherein the electronic component is a power device.
[12] An electronic component sealant, comprising the silicone gel-forming composition according to any one of [1] to [11].
[13] The electronic component sealant according to [12], which is substantially transparent.
[14] A silicone gel obtained by curing the silicone gel-forming composition according to any one of [1] to [11] or the electronic component sealant according to [12] or [13].
[15] The silicone gel according to [14], wherein the 1/4 cone penetration value as specified in JIS K2210 is 10 to 150.
[16] An electronic component, comprising the silicone gel according to [14] or [15].
[17] A method for manufacturing an electronic component, the method comprising a step for using the silicone gel-forming composition according to any one of [1] to [11] or the electronic component sealant according to [12] or [13].

### EFFECT OF THE INVENTION

According to one embodiment of the present invention, provided is a silicone gel-forming composition having excellent heat resistance. According to a preferred embodiment of the present invention, provided is a silicone gel-forming composition that can provide a silicone gel with little change in degree of curing even after exposure to a high-temperature environment for a long period of time (e.g., 2000 hours).

### DESCRIPTION OF THE PREFERRED EMBODIMENTS

For the numerical ranges described in the present specification, the upper and lower limits can be combined as desired. For example, when the numerical range is described as "preferably 30 to 100, more preferably 40 to 80". The ranges "30 to 80" and "40 to 100" are also included in the numerical range described in the present specification. Furthermore, for example, when the numerical range is described as "preferably 30 or more, more preferably 40 or more, and preferably 100 or less, more preferably 80 or less", the ranges "30 to 80" and "40 to 100" are also included in the numerical range described in the present specification.
In addition, as a numerical range described in the present specification, for example, the statement "60 to 100" means that the range is "60 or more and 100 or less".

### 1. Silicone Gel-Forming Composition

One aspect of the present invention provides a silicone gel-forming composition (hereinafter also referred to as "the composition of the present invention"). The composition of the present invention contains the following components (A) to (E): (A) an organopolysiloxane having, on average, two or more alkenyl groups bonded to a silicon atom in one molecule; (B) an organohydrogenpolysiloxane having two or more hydrogen atoms bonded to silicon atoms in one molecule; (C) an organosiloxane compound having one hydrogen atom bonded to a silicon atom in one molecule (excluding compounds having an alkoxysilyl group); (D) a hydrosilylation reaction catalyst; and (E) a heat-resistant additive, wherein the molar ratio of silicon atom-bonded hydrogen atoms in components (B) and (C) to alkenyl groups in component (A) is 0.80 or greater.
Each component constituting the composition of the present invention will be described in detail below.

### 1.1 Component (A): Organopolysiloxane

Component (A) is an organopolysiloxane serving as a base polymer. The composition of the present invention contains, as component (A), an organopolysiloxane having, on average, two or more alkenyl groups bonded to a silicon atom in one molecule.
In one embodiment of the present invention, the alkenyl group may be an alkenyl group with 2 to 12 carbon atoms. Specific examples of alkenyl groups with 2 to 12 carbon atoms include vinyl groups, propenyl groups (including allyl groups), butenyl groups, pentenyl groups, hexenyl groups, heptenyl groups, octenyl groups, nonenyl groups, decenyl groups, undecenyl groups, dodecenyl groups, and the like. Note that these groups also include structural isomers.
In one embodiment of the present invention, the alkenyl group is preferably an alkenyl group with 2 to 10 carbon atoms, more preferably an alkenyl group with 2 to 8 carbon atoms, still more preferably a group selected from the group consisting of vinyl groups, allyl groups, and hexenyl groups, and particularly preferably a vinyl group.

In component (A), the silicon atom-bonded group other than the alkenyl group may be the monovalent hydrocarbon group with 1 to 12 carbon atoms and no aliphatic unsaturated bonds.
Specific examples of monovalent hydrocarbon groups with 1 to 12 carbon atoms and no aliphatic unsaturated bonds include alkyl groups, aryl groups, aralkyl groups, halogenated alkyl groups, and the like.
Specific examples of the alkyl group include methyl groups, ethyl groups, n-propyl groups, isopropyl groups, and other propyl groups, n-butyl groups, isobutyl groups, s-butyl groups, t-butyl groups, and other butyl groups, pentyl groups, hexyl groups, heptyl groups, octyl groups, nonyl groups, decyl groups, undecyl groups, dodecyl groups, and the like. Note that these groups also include structural isomers.
Specific examples of the aryl group include phenyl groups, tolyl groups, xylyl groups, naphthyl groups, and the like.
Specific examples of the aralkyl group include benzyl groups, phenethyl groups, 3-phenylpropyl groups, 4-phenylbutyl group, and the like.
The halogenated alkyl group may be a group in which some or all of hydrogen atoms bonded to carbon atoms in the alkyl group have been substituted with chlorine atoms, bromine atoms, or other halogen atoms, and specific examples include chloromethyl groups, 3-chloropropyl groups, 3,3,3-trifluoropropyl groups, and the like.
Of these, the monovalent hydrocarbon group is preferably an alkyl group with 1 to 6 carbon atoms, more preferably an alkyl group with 1 to 4 carbon atoms, and even more preferably a methyl group.

The molecular structure of component (A) may be linear, partially branched linear, branched, cyclic, network, dendritic, or the like.
In one embodiment of the present invention, component (A) is a mixture of two or more of these molecular structures. In another embodiment of the present invention, component (A) is at least one selected from the group consisting of linear organopolysiloxanes, branched organopolysiloxanes, and mixtures thereof.

Specific examples of linear organopolysiloxanes include dimethylsiloxane-methylvinylsiloxane copolymers blocked at both molecular chain ends with trimethylsiloxy groups, dimethylsiloxane-methylvinylsiloxane-methylphenylsiloxane copolymers blocked at both molecular chain ends with trimethylsiloxy groups, dimethylpolysiloxanes blocked at both molecular chain ends with dimethylvinylsiloxy groups, methylphenylpolysiloxanes blocked at both molecular chain ends with dimethylvinylsiloxy groups, dimethylsiloxane-methylvinylsiloxane copolymers blocked at both molecular chain ends with dimethylvinylsiloxy groups, dimethylpolysiloxane-methylphenylpolysiloxane copolymers blocked at both molecular chain ends with dimethylvinylsiloxy groups, dimethylsiloxane-methylvinylsiloxane copolymers blocked at both molecular chain ends with dimethylphenylsiloxy groups, dimethylpolysiloxanes blocked at both molecular chain ends with methylvinylphenylsiloxy groups, and the like.

Examples of branched organopolysiloxanes include MQ resins, MDQ resins, MTQ resins, MDTQ resins, TD resins, TQ resins, TDQ resins, and the like, which contain any combination of triorganosiloxy units (M units) (organo groups are methyl groups only, or methyl groups and vinyl groups or phenyl groups), diorganosiloxy units (D units) (organo groups are methyl groups only, or methyl groups and vinyl groups or phenyl groups), monoorganosiloxy units (T units) (organo groups are methyl groups, vinyl groups, or phenyl groups), and siloxy units (Q units).

In one embodiment of the present invention, the viscosity of component (A) at 25°C is, for example, in the range of 10 to 10,000 mPa·s, preferably 20 to 10,000 mPa·s, and more preferably 100 to 5,000 mPa·s.

If the viscosity of component (A) is at or above the lower limit of the range above, the physical properties of the resulting silicone gel, particularly flexibility and elongation, can be significantly improved. Furthermore, if the viscosity of component (A) is at or below the upper limit of the range above, the handleability of the resulting silicone gel can be improved.

Note that in the present specification, viscosity refers to a value measured at 25°C using a Brookfield viscometer.

### 1.2 Component (B): Organohydrogenpolysiloxane

Component (B) is an organohydrogenpolysiloxane functioning as a primary crosslinking agent. The composition of the present invention contains, as component (B), an organohydrogenpolysiloxane having two or more hydrogen atoms bonded to silicon atoms in one molecule.
Component (B) is a compound containing a hydrosilyl group (-SiH) that is added to the monovalent hydrocarbon group having an aliphatic unsaturated bond in component (A) during a hydrosilylation reaction.

Specific examples of the organohydrogenpolysiloxane of component (B) include 1,1,3-3-tetramethyl disiloxanes, 1,3,5,7-tetramethyl cyclotetrasiloxanes, tris(dimethyl hydrogensiloxy) methylsilanes, tris(dimethyl hydrogensiloxy) phenylsilanes, 1-(3-glycidoxypropyl)-1,3,5,7-tetramethyl cyclotetrasiloxanes, 1,5-di(3-glycidoxypropyl)-1,3,5,7-tetramethyl cyclotetrasiloxanes, 1-(3-glycidoxypropyl)-5-trimethoxysilyl ethyl-1,3,5,7-tetramethyl cyclotetrasiloxanes, methylhydrogenpolysiloxanes blocked at both molecular chains ends with a trimethylsiloxy, dimethylsiloxane-methylhydrogensiloxane copolymers blocked at both molecular chains ends with trimethylsiloxy groups, dimethylpolysiloxanes blocked at both molecular chains ends with dimethylhydrogensiloxy groups, dimethylsiloxane-methylhydrogensiloxane copolymers blocked at both molecular chains ends with dimethylhydrogensiloxy groups, methylhydrogensiloxane-diphenylsiloxane copolymers blocked at both molecular chains ends with trimethylsiloxane groups, methylhydrogensiloxane-diphenylsiloxane-dimethylsiloxane copolymers blocked at both molecular chains ends with trimethylsiloxy groups, hydrolysis condensates of trimethoxysilane, copolymers containing (CH₃)₂HSiO_{1/2} units and SiO_{4/2} units, copolymers containing (CH₃)₂HSiO_{1/2} units, SiO_{4/2} units, and (C₆H₅)SiO_{3/2} units, mixtures of two or more thereof, and the like.

In one embodiment of the present invention, the viscosity of component (B) at 25°C is, for example, in the range of 2 to 1,000 mPa·s, preferably 2 to 500 mPa·s, more preferably 2 to 100 mPa·s, and even more preferably 5 to 50 mPa·s.
If the viscosity of component (B) is at or above the lower limit of the range above, the physical properties of the resulting silicone gel, particularly flexibility and elongation, can be significantly improved. Furthermore, if the viscosity of component (B) is at or below the upper limit of the range above, the handleability of the resulting silicone gel can be improved.

In one embodiment of the present invention, the amount of component (B) is preferably in the range of 0.1 to 20 parts by mass, more preferably 0.2 to 10 parts by mass, and even more preferably 0.4 to 6 parts by mass per 100 parts by mass of component (A).
If the amount of component (B) is at or above the lower limit of the range above, the curability of the composition can be improved. Furthermore, if the amount of component (B) is at or below the upper limit of the range above, foaming and changes in hardness at high temperatures are suppressed, and the heat resistance of a cured product (silicone gel) can be further improved. Furthermore, if the amount of component (B) is at or below the upper limit of the range above, production costs can be sufficiently reduced.

Furthermore, in one embodiment of the present invention, the amount of component (B) is an amount such that the molar ratio of silicon atom-bonded hydrogen atoms in component (B) to alkenyl groups in component (A) is 0.10 or more, 0.20 or more, or 0.30 or more. If the amount of component (B) is at or above the molar ratio above, the curability of the composition can be improved.
The upper limit of the molar ratio is not particularly limited, but may be, for example, 1.00 or less, 0.90 or less, or 0.80 or less.

### 1.3 Component (C): Organosiloxane Compound

Component (C) is an organosiloxane compound having SiH groups that can cap the alkenyl groups of component (A) by undergoing a hydrosilylation reaction with the alkenyl groups of component (A). The composition of the present invention contains, as component (C), an organosiloxane compound having one hydrogen atom bonded to a silicon atom in one molecule. In the composition of the present invention, component (C) does not contain a compound having an alkoxysilyl group (0 mass %).
Silicon atom-bonded groups other than silicon atom-bonded hydrogen atoms in component (C) may be, for example, monovalent hydrocarbon groups with 1 to 12 carbon atoms and no aliphatic unsaturated bonds. The monovalent hydrocarbon group may be the same as those described in "1.1 Component (A): Organopolysiloxane".
In the present invention, by using the abovementioned component (C), which does not contain a compound having an alkoxysilyl group that is a hydrolyzable group, in combination with component (E) to be described later, the heat resistance of a silicone gel obtained by curing the composition of one embodiment of the present invention can be stably maintained over an extended period of time. On the other hand, even when components (C) and (E) are used in combination, if the composition of the present invention contains a large amount of the abovementioned compound having an alkoxysilyl group (i.e., an organosiloxane compound having one hydrogen atom bonded to a silicon atom and one or more alkoxysilyl group in one molecule), the effect of improving heat resistance over an extended period of time may be reduced. In other words, in one embodiment of the composition of the present invention, the amount of the organosiloxane compound having one hydrogen atom bonded to a silicon atom and one or more alkoxysilyl group in one molecule is, from the perspective of further improving the heat resistance of the cured product (silicone gel), preferably 5 parts by mass or less, more preferably 1 part by mass or less, even more preferably 0.1 parts by mass or less, and particularly preferably 0 parts by mass (i.e., the composition of the present invention does not contain the compound above) per 100 parts by mass of component (A).

In one embodiment of the present invention, component (C) contains at least one selected from the group consisting of compounds expressed by the following general formulas (1) to (7).

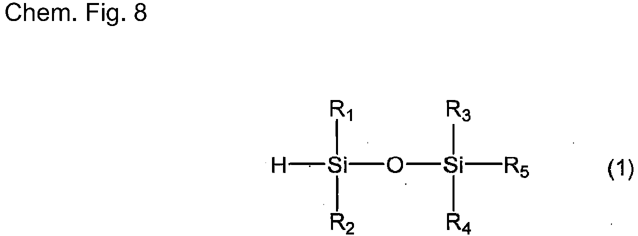

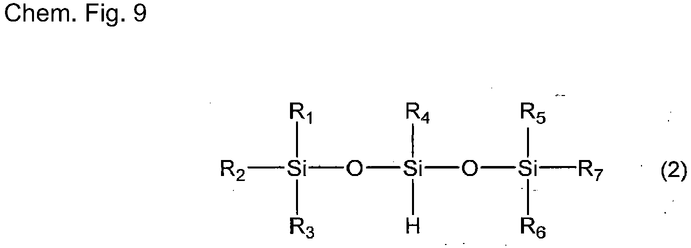

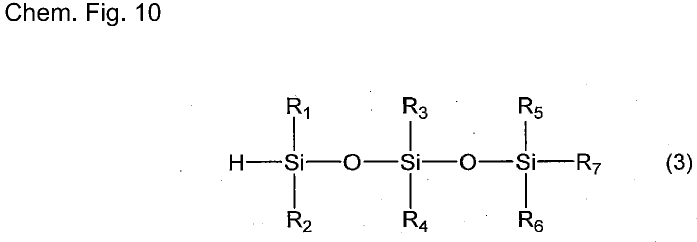

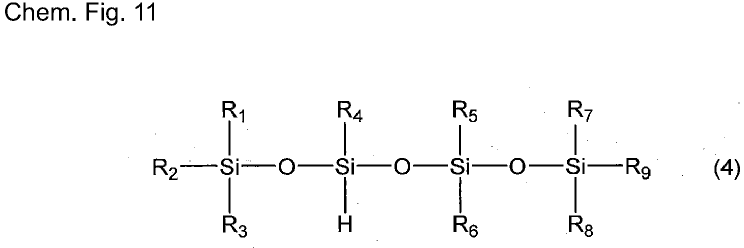

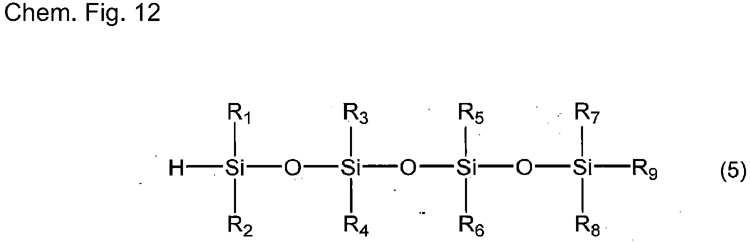

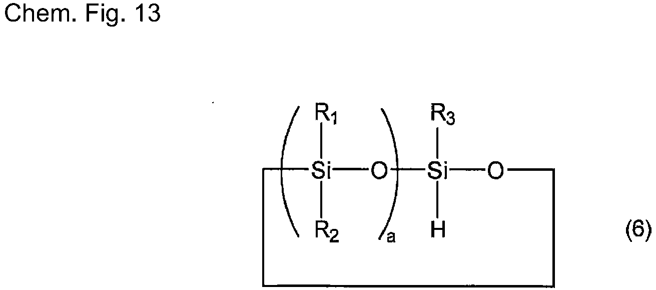

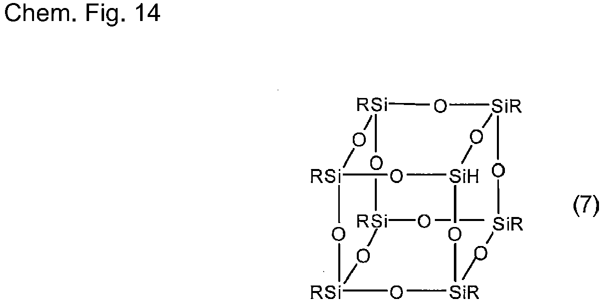

In general formula (1) above, R₁ to R₅ are each independently the same or different monovalent hydrocarbon groups with 1 to 12 carbon atoms and no aliphatic unsaturated bonds. The monovalent hydrocarbon groups may be the same or different groups.
Specific examples of the monovalent hydrocarbon groups include alkyl groups, aryl groups, aralkyl groups, halogenated alkyl groups, and the like.
Specific examples of the alkyl group include methyl groups, ethyl groups, n-propyl groups, isopropyl groups, and other propyl groups, n-butyl groups, isobutyl groups, s-butyl groups, t-butyl groups, and other butyl groups, pentyl groups, hexyl groups, heptyl groups, octyl groups, nonyl groups, decyl groups, undecyl groups, dodecyl groups, and the like. Note that these groups also include structural isomers.
Specific examples of the aryl group include phenyl groups, tolyl groups, xylyl groups, naphthyl groups, and the like.
Specific examples of the aralkyl group include benzyl groups, phenethyl groups, 3-phenylpropyl groups, 4-phenylbutyl group, and the like.
The halogenated alkyl group may be a group in which some or all of hydrogen atoms bonded to carbon atoms in the alkyl group have been substituted with chlorine atoms, bromine atoms, or other halogen atoms, and specific examples include chloromethyl groups, 3-chloropropyl groups, 3,3,3-trifluoropropyl groups, and the like.
Of these, the monovalent hydrocarbon group is preferably an alkyl group with 1 to 6 carbon atoms, more preferably an alkyl group with 1 to 4 carbon atoms, and even more preferably a methyl group.

In general formula (2) above, R₁ to R₃ and R₅ to R₇ are each independently a monovalent hydrocarbon group with 1 to 12 carbon atoms and no aliphatic unsaturated bonds, and R₄ is a group selected from: monovalent hydrocarbon groups with 1 to 12 carbon atoms and no aliphatic unsaturated bonds; and trimethylsiloxy groups.
The monovalent hydrocarbon groups that can be selected as R₁ to R₃ and R₅ to R₇ may be the same or different groups.
Furthermore, the monovalent hydrocarbon group may be the same as those described in general formula (1) above.

In general formula (3) above, R₁, R₂, and R₅ to R₇ are each independently a monovalent hydrocarbon group with 1 to 12 carbon atoms and no aliphatic unsaturated bonds, and R₃ and R₄ are each independently a group selected from: monovalent hydrocarbon groups with 1 to 12 carbon atoms and no aliphatic unsaturated bonds; and trimethylsiloxy groups.
The monovalent hydrocarbon groups may be the same or different groups.
Furthermore, the monovalent hydrocarbon group may be the same as those described in general formula (1) above.

In general formula (4) above, R₁ to R₃, and R₇ to R₉ are each independently a monovalent hydrocarbon group with 1 to 12 carbon atoms and no aliphatic unsaturated bonds, and R₄ to R₆ are each independently a group selected from: monovalent hydrocarbon groups with 1 to 12 carbon atoms and no aliphatic unsaturated bonds; and trimethylsiloxy groups.
The monovalent hydrocarbon groups may be the same or different groups.
Furthermore, the monovalent hydrocarbon group may be the same as those described in general formula (1) above.

In general formula (5) above, R₁, R₂, and R₇ to R₉ are each independently a monovalent hydrocarbon group with 1 to 12 carbon atoms and no aliphatic unsaturated bonds, and R₃ to R₆ are each independently a group selected from: monovalent hydrocarbon groups with 1 to 12 carbon atoms and no aliphatic unsaturated bonds; and trimethylsiloxy groups.
The monovalent hydrocarbon groups may be the same or different groups.
Furthermore, the monovalent hydrocarbon group may be the same as those described in general formula (1) above.

In general formula (6) above, R₁ and R₂ are each independently a monovalent hydrocarbon group with 1 to 12 carbon atoms and no aliphatic unsaturated bonds, and R₃ is a group selected from: monovalent hydrocarbon groups with 1 to 12 carbon atoms and no aliphatic unsaturated bonds; and trimethylsiloxy groups. a is an integer of 2 to 5.
The monovalent hydrocarbon groups may be the same or different groups.
Furthermore, the monovalent hydrocarbon group may be the same as those described in general formula (1) above.
a may be an integer of 2 to 4, an integer of 2 to 3, or 2.

In general formula (7) above, each R is independently the same or different monovalent hydrocarbon groups with 1 to 12 carbon atoms and no aliphatic unsaturated bonds.
The monovalent hydrocarbon groups may be the same or different groups.
Furthermore, the monovalent hydrocarbon group may be the same as those described in general formula (1) above.

Note that the abovementioned compound having an alkoxysilyl group includes, for example, a compound having a structure of the following formula (8).

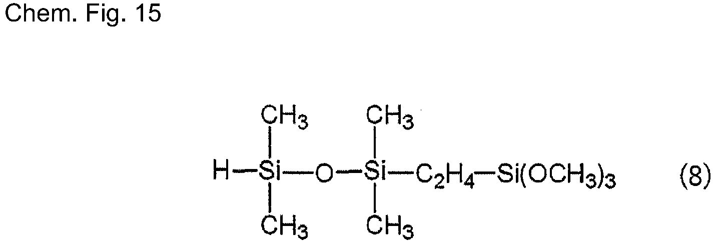

In one embodiment of the present invention, the amount of component (C) is preferably in the range of 0.1 to 10 parts by mass, more preferably 0.2 to 8 parts by mass, and even more preferably 0.4 to 4 parts by mass per 100 parts by mass of component (A).
If the amount of component (C) is at or above the lower limit of the range above, the heat resistance of the composition can be improved. Furthermore, if the amount of component (C) is at or below the upper limit of the range above, foaming and changes in hardness at high temperatures are suppressed, and the heat resistance of a cured product (silicone gel) can be further improved. Furthermore, if the amount of component (B) is at or below the upper limit of the range above, production costs can be sufficiently reduced.

Furthermore, in one embodiment of the present invention, the amount of component (C) is preferably an amount such that the molar ratio of silicon atom-bonded hydrogen atoms in components (B) and (C) to alkenyl groups in component (A) is 0.80 or more, greater than 0.80, 0.85 or more, or 0.90 or more. If the amount of component (B) is at or above the molar ratio above, the curability of the composition can be improved.
The upper limit of the molar ratio is not particularly limited, but may be, for example, 5.00 or less, 3.00 or less, 2.00 or less, or 1.50 or less.

### 1.4 Component (D): Hydrosilylation Reaction Catalyst

Component (D) is a component for accelerating a hydrosilylation reaction and curing the composition of the present invention. Specific examples of the hydrosilylation reaction catalyst include platinum-based catalysts, rhodium-based catalysts, palladium-based catalysts, and the like. Of these, platinum-based catalysts are preferred due to being able to significantly accelerate curing.
Specific examples of the platinum-based catalyst include catalyst platinum fine powders, chloroplatinic acids, alcohol solutions of chloroplatinic acid, platinum-alkenylsiloxane complexes, platinum-olefin complexes, platinum-carbonyl complexes, and catalysts in which these platinum-based catalysts are dispersed or encapsulated with a thermoplastic resin such as silicone resin, polycarbonate resin, acrylic resin, or the like.
Of these, platinum-alkenylsiloxane complexes are preferable. The alkenylsiloxane may be: 1,3-divinyl-1,1,3,3-tetramethyldisiloxane; 1,3,5,7-tetramethyl-1,3,5,7-tetravinylcyclotetrasiloxane; an alkenylsiloxane obtained by substituting, with an ethyl group, a phenyl group, or the like, a portion of the methyl groups of the alkenylsiloxanes; an alkenylsiloxane obtained by substituting, with an allyl group, a hexenyl group, or the like, a portion of the vinyl groups of these alkenylsiloxanes; or the like.
The platinum-alkenylsiloxane complex has favorable stability, and therefore, 1,3-divinyl-1,1,3,3-tetramethyldisiloxane is particularly preferable.
Note that examples of the catalyst for accelerating the hydrosilylation reaction also include non-platinum-based metal catalysts such as iron, ruthenium, iron/cobalt, and the like.

Furthermore, the hydrosilylation reaction catalyst may also be a high-energy beam-activated catalyst (also called a photoactivated catalyst) that accelerates the hydrosilylation reaction upon irradiation with ultraviolet rays or other high-energy beams. Examples of high-energy beams include ultraviolet rays, gamma rays, X-rays, alpha rays, electron beams, and the like.
Specific examples of the high-energy beam-activated catalyst include (methylcyclopentadienyl)trimethylplatinum(IV), (cyclopentadienyl)trimethylplatinum(IV), (1,2,3,4,5-pentamethylcyclopentadienyl)trimethylplatinum(IV), (cyclopentadienyl)dimethylethylplatinum(IV), (cyclopentadienyl)dimethylacetylplatinum(IV), (trimethylsilylcyclopentadienyl)trimethylplatinum(IV), (methoxycarbonylcyclopentadienyl)trimethylplatinum(IV), (dimethylphenylsilylcyclopentadienyl)trimethylcyclopentadienylplatinum(IV), trimethyl(acetylacetonato)platinum(IV), trimethyl(3,5-heptanedionato)platinum(IV), trimethyl(methylacetoacetate)platinum(IV), bis(2,4-pentanedionato)platinum(II), bis(2,4-hexanedionato)platinum(II), bis(2,4-heptanedionato)platinum(II), bis(3,5-heptanedionato)platinum(II), bis(1-phenyl-1,3-butanedionato)platinum(II), bis(1,3-diphenyl-1,3-propanedionato)platinum(II), bis(hexafluoroacetylacetonato)platinum(II), and the like.

In one embodiment of the present invention, the amount of component (D) is in the range of 0.001 to 5 parts by mass, 0.01 to 3 parts by mass, or 0.01 to 2 parts by mass per 100 parts by mass of component (A).

Furthermore, in one embodiment of the present invention, the amount of component (D) is preferably in the range of 0.01 to 1,000 ppm by mass, more preferably 0.01 to 500 ppm by mass, and even more preferably 0.01 to 200 ppm by mass, of metal atoms in the catalyst, based on the total amount of the silicone gel-forming composition.

### 1.5 Component (E): Heat-Resistant Additive

Component (E) is a component for imparting heat resistance to the composition of the present invention. The heat-resistant additive has an effect of suppressing increase in hardness of a resin by, for example, cleaving a dimethylsiloxane chain length, or the like in response to oxidative deterioration of a silicone gel that progresses in a high-temperature environment such as 180°C or higher or the like.

In the present invention, the heat-resistant additive of component (E) is not particularly limited so long as the component can impart heat resistance, and any additive known in the technical field can be used. In one embodiment, the heat-resistant additive preferably can make the silicone gel-forming composition of one embodiment of the present invention substantially transparent. Note that the term "substantially transparent" will be described later.

The composition of one embodiment of the present invention contains, as component (E), at least one selected from the group consisting of metal silanolates and metal carboxylates. Metal silanolates are silicon-containing compounds having at least one unit in which a metal atom is bonded to a silicon atom via an oxygen atom. Furthermore, metal carboxylates are salts of a metal atom and a carboxylic acid.
Specific examples of metals that form metal silanolates and metal carboxylates include cerium (Ce) (including trivalent and tetravalent), iron (Fe) (including divalent and trivalent), manganese (Mn), vanadium (V), magnesium (Mg), aluminum (Al), nickel (Ni), titanium (Ti), zinc (Zn), niobium (Nb), and the like. In one embodiment of the present invention, the metal is cerium (Ce) or iron (Fe).
Furthermore, the carboxylic acid in the metal carboxylate may specifically be, for example: an ethanoic acid (acetic acid), propanoic acid (propionic acid), butanoic acid (butyric acid), pentanoic acid, hexanoic acid, heptanoic acid, octanoic acid, nonanoic acid, decanoic acid (capric acid), dodecanoic acid (lauric acid), tetradecanoic acid (myristic acid), octadecanoic acid (stearic acid), oleic acid, or other linear aliphatic carboxylic acid; a 2-methylbutanoic acid, 2-methylpentanoic acid, 2-ethylhexanoic acid, 2-methylheptanoic acid, 4-methyloctanoic acid, 3,5,5-trimethylhexanoic acid, or other branched aliphatic carboxylic acid; or a naphthenic acid or other alicyclic carboxylic acid; or the like.

Specific examples of metal silanolates include cerium silanolates, iron silanolates, manganese silanolates, vanadium silanolates, magnesium silanolates, aluminum silanolates, nickel silanolates, titanium silanolates, zinc silanolates, niobium silanolates, and the like.
Specific examples of metal carboxylates include cerium carboxylates, iron carboxylates, manganese carboxylates, vanadium carboxylates, magnesium carboxylates, aluminum carboxylates, nickel carboxylates, titanium carboxylates, zinc carboxylates, niobium carboxylates, and the like.
These metal silanolates and metal carboxylates may be used independently or in combination of two or more.
In one embodiment of the present invention, component (E) includes at least one selected from the group consisting of cerium silanolates, iron silanolates, cerium carboxylates, and iron carboxylates.

The metal silanolate to be used may be synthesized by a known method, or may be a commercially available product. Metal silanolates can be synthesized by referring to descriptions in, for example, International Patent Application Publication WO 2022/013917, Japanese PCT Application 2019-518777, and the like.

In one embodiment of the present invention, the heat-resistant additive of component (E) may include a reaction product obtained by heat-treating a metal carboxylate and an organopolysiloxane. The reaction product can be synthesized by referring to descriptions in, for example, Japanese Unexamined Patent Application 2015-7203 and the like.

The amount of component (E) is preferably 0.02 to 5 parts by mass, more preferably 0.02 to 3 parts by mass, and even more preferably 0.20 to 1 part by mass, per 100 parts by mass of component (A).
Furthermore, the amount of component (E) is preferably an amount such that the amount of metal atoms in component (E) is 1 to 500 ppm by mass, more preferably 10 to 300 ppm by mass, relative to the total amount of the composition.
By adjusting the amount of component (E) to be within this range, the heat resistance of the resulting silicone gel can be improved.

### 1.6 Optional Components

In addition to components (A) to (E), the composition of one embodiment of the present invention may contain, as necessary; another organopolysiloxane; an adhesion-imparting agent; a curing inhibitor; silica, glass, alumina, zinc oxide, or other inorganic filler; polymethacrylate and another fine organic resin powder; a phosphor; a dye; a pigment; a flame retardancy-imparting agent; a solvent; and the like.

In one embodiment of the present invention, the adhesion-imparting agent includes, for example, 1,6-bis(trimethoxysilyl)hexane, 1,6-bis(triethoxysilyl)hexane, 1,4-bis(trimethoxysilyl)hexane, 1,5-bis(trimethoxysilyl)hexane, 2,5-bis(trimethoxysilyl)hexane, 1-methyldimethoxysilyl-6-trimethoxysilylhexane, 1-phenyldiethoxysilyl-6-triethoxysilylhexane, 1,6-bis(methyldimethoxysilyl)hexane, and the like.

In one embodiment of the present invention, curing inhibitors include, for example: 2-methyl-3-butyn-2-ol, 3,5-dimethyl-1-hexyn-3-ol, 2-phenyl-3-butyn-2-ol, 1-ethynylcyclohexanol, and other acetylenic compounds; 3-methyl-3-penten-1-yne, 3,5-dimethyl-3-hexen-1-yne, and other eneyne compounds; 1,3,5,7-tetramethyl-1,3,5,7-tetravinylcyclotetrasiloxane and 1,3,5,7-tetramethyl-1,3,5,7-tetrahexenylcyclotetrasiloxane; benzotriazole and other triazoles; phosphines; mercaptans; hydrazines; and the like.

### 1.7 Manufacturing Method and Form of the Composition of the Present Invention

The composition of one embodiment of the present invention can be manufactured by uniformly mixing components (A) to (E) and any optional components used as needed at room temperature (e.g., 15 to 30°C) using mechanical force such as a mixer or the like.
Furthermore, the composition of one embodiment of the present invention may be a one-component type composition, or may be a multi-component type composition of two or more components type.

### 1.8 Properties of the Composition of the Present Invention

The composition of one embodiment of the present invention preferably has a viscosity at 25°C in the range of 100 to 10,000 mPa·s, more preferably 200 to 8,000 mPa·s, and even more preferably 300 to 5,000 mPa·s.
Furthermore, the composition of one embodiment of the present invention is substantially transparent. In the present specification, the term "substantially transparent" means that when the composition or the silicone gel to be described later is placed in a glass container or the like, the bottom (contact surface) of the glass container or the like can be seen visually through the composition or silicone gel. Furthermore, whether or not something is "substantially transparent" may be determined by visible light transmittance. For example, a material having a visible light transmittance of 80% or more, preferably 85% or more, more preferably 90% or more, and even more preferably 95% or more can be determined to be "substantially transparent".

### 1.9 Use of the Composition of the Present Invention

The composition according to one embodiment of the present invention can be used to seal an electronic component due to being able to stably maintain excellent heat resistance over an extended period of time.
Specific examples of the electronic component include electrical and electronic devices. The electrical and electronic devices may include electrical circuits, electrodes, or the like in which a metal electrode (silver, copper, aluminum, gold, or the like) and a metal oxide film electrode (ITO (indium tin oxide), or the like) are formed on a base material such as glass, epoxy resin, polyimide resin, phenolic resin, ceramics, or the like.
Furthermore, the electronic component includes, for example, peripheral components of the abovementioned electrical and electronic devices, electronic control units (ECUs) and other in-vehicle electronic components, in-vehicle component cases, terminal boxes, lighting components, and solar cell modules, and other metal and/or resin structures that require durability, water resistance, and other properties, and the like.
Furthermore, the electronic component includes, for example, power devices (power semiconductors) and the like for engine control (in transportation equipment), power/train systems, air conditioning control, and the like.
The composition of one embodiment of the present invention can be suitably used as an adhesive, potting material, coating material, sealing material, or the like for protecting or adhering such electronic component.

### 2. Electronic Component Sealant

One aspect of the present invention provides an electronic component sealant (hereinafter also referred to as the "electronic component sealant of the present invention") that contains the silicone gel-forming composition described above in "1. Silicone Gel-Forming Composition".
The components, composition, and the like of the silicone gel-forming composition included in the electronic component sealant of the present invention are the same as matters described above in "1. Silicone Gel-Forming Composition".
Furthermore, an electronic component to which the electronic component sealant of the present invention can be applied is the same as the matters described above in "1.9 Use of the Composition of the Present Invention".

The amount of the silicone gel-forming composition in the electronic component sealant of one embodiment of the present invention is not particularly limited, and may be 30 to 100 mass%, 40 to 99 mass%, or 50 to 98 mass% relative to the total amount (100 mass%) of the electronic component sealant.
In some embodiments, the electronic component sealant of the present invention may consist essentially of the silicone gel-forming composition of one embodiment of the present invention. In the present specification, the phrase "consist essentially of the silicone gel-forming composition of one embodiment of the present invention" means that other components such as impurities and the like that may be unavoidably in the silicone gel-forming composition during a manufacturing process may also be included. In this embodiment, the electronic component sealant of the present invention may contain, for example, 5 mass% or less, 4 mass% or less, 3 mass% or less, 2 mass% or less, 1.0 mass% or less, or 0.5 mass% or less of other components, relative to the total amount (100 mass%) of the electronic component sealant.

The electronic component sealant of one embodiment of the present invention is substantially transparent.

### 3. Method for Curing the Composition of the Present Invention and Silicone Gel

One aspect of the present invention provides a silicone gel (hereinafter also referred to as the "silicone gel of the present invention") obtained by curing the silicone gel-forming composition described above in "1. Silicone Gel-Forming Composition" or the electronic component sealant described above in "2. Electronic Component Sealant".
The silicone gel of the present invention can be prepared by curing the silicone gel-forming composition of one embodiment of the present invention under temperature conditions appropriate for the intended use.
The temperature for curing the silicone gel-forming composition is not particularly limited, but is generally within the range of 25°C to 150°C.

The silicone gel of one embodiment of the present invention preferably has a 1/4 cone penetration value (initial penetration) as specified in JIS K2210 of 10 to 150, more preferably 20 to 120, and even more preferably 30 to 100.

The silicone gel of one embodiment of the present invention preferably has a 1/4 cone penetration value after being held at a high temperature exceeding 210°C for 1000 hours or longer and then cooled to room temperature to 25°C (penetration after 1000 hours) of 10 to 150, more preferably 20 to 120, and even more preferably 30 to 100.
The silicone gel of one embodiment of the present invention preferably has a 1/4 cone penetration value after being held at a high temperature exceeding 210°C for 2000 hours or longer and then cooled to room temperature to 25°C (penetration after 2000 hours) of 10 to 150, more preferably 20 to 120, and even more preferably 30 to 100.

In the silicone gel of one embodiment of the present invention, the rate of change in penetration after 1000 hours from the initial penetration is preferably within 40%, more preferably within 35%, and even more preferably within 30%.
In the silicone gel of one embodiment of the present invention, the rate of change in penetration after 2000 hours from the initial penetration is preferably within 50%, more preferably within 45%, and even more preferably within 40%.

### 4. Electronic Component and Method for Manufacturing Electronic Component

One aspect of the present invention provides an electronic component (hereinafter also referred to as "electronic component of the present invention") that includes the silicone gel described above in "3. Method for Curing the Composition of the Present Invention and Silicone Gel".
Specific examples of the electronic component include the same as those described above in "1.9 Use of the Composition of the Present Invention".
The electronic component of one embodiment of the present invention includes a cured layer containing the silicone gel of one embodiment of the present invention. The cured layer may have a thickness of 1 to 50 mm, 2 to 40 mm, 5 to 30 mm, 5 to 20 mm, or 5 to 10 mm, on the basis of the type of the electronic component.

Furthermore, as one aspect, the present invention provides a method for manufacturing an electronic component (hereinafter also referred to as the "method for manufacturing an electronic component of the present invention"), which includes using the silicone gel-forming composition described above in "1. Silicone Gel-Forming Composition" or the electronic component sealant described above in "2. Electronic Component Sealant".
Specific examples of the electronic component include the same as those described above in "1.9 Use of the Composition of the Present Invention".
Furthermore, the use is not particularly limited, and may involve applying the silicone gel-forming composition of the present invention or the electronic component sealant of the present invention to an electronic component as an adhesive, potting material, coating material, sealing material, or the like at any stage in the manufacturing process of the target electronic component. The amount or range of application can be appropriately designed on the basis of the type of the electronic component.

### EXAMPLES

The present invention is further described below on the basis of Examples, but the present invention is not limited to the Examples below.

Silicone gel-forming compositions of Examples 1 to 9 and Comparative Examples 1 to 4 were prepared by uniformly mixing components listed below in the ratios depicted in Table 1. These compositions were cured by a method to be described later, and resulting cured products (silicone gels) were evaluated for 1/4 cone penetration and heat resistance. The evaluation results are depicted in Table 1. Note that in Table 1, the composition of each component is depicted as parts by mass relative to 100 parts by mass of component (A). Furthermore, in Table 1, "H/Vi (component (B)/component (A))" represents the total mols of silicon atom-bonded hydrogen atoms in component (B) per mol of total vinyl groups in component (A). Similarly, in Table 1, "H/Vi (components (B) + (C)/component (A))" represents the total mols of silicon atom-bonded hydrogen atoms in component (B) and component (C) per mol of total vinyl groups in component (A).

### Component (A)

- Component (A-1): A linear dimethylpolysiloxane blocked at both molecular chain ends with dimethylvinylsiloxy groups, the dimethylpolysiloxane being expressed by the following formula:

   ((CH₃)₂(CH₂=CH)SiO_{1/2})₂((CH₃)₂SiO_{2/2})₁₆₀

   (viscosity: 430 mPa·s, amount of vinyl groups: 0.44 mass%)
- Component (A-2): A branched polyorganosiloxane containing 91.7 mol% of a (CH₃)₂SiO_{2/2} unit, 5.3 mol% of a CH₃SiO_{3/2} unit, 2.4 mol% of a (CH₃)SiO_{1/2} unit, and 0.6 mol% of a (CH₃)₂(CH₂=CH)SiO_{1/2} unit (viscosity: 680 mPa·s, amount of vinyl groups: 0.20 mass%)
- Component (A-3): A branched polyorganosiloxane containing 98.4 mol% of a (CH₃)₂SiO_{2/2} unit, 0.3 mol% of a CH₃SiO_{4/2} unit, 0.2 mol% of a (CH₃)SiO_{1/2} unit, and 1.1 mol% of a (CH₃)₂(CH₂=CH)SiO_{1/2} unit (viscosity: 500 mPa·s, amount of vinyl groups: 0.46 mass%)
- Component (A-4): A dimethylpolysiloxane-methylphenylpolysiloxane copolymer blocked at both ends with dimethylvinylsiloxy groups, the copolymer being expressed by the following formula:

   ((CH₃)₂(CH₂=CH)SiO_{1/2})₂((CH₃)₂SiO_{2/2})₂₅₀((CH₃)(C₆H₅)SiO_{2/2})₁₅

   (viscosity: 3200 mPa·s, amount of vinyl groups: 0.25 mass%)
Note that each of the abovementioned components (A-1) to (A-4) has, on average, two or more alkenyl groups bonded to silicon atoms in one molecule.

### Component (B)

- Component (B-1): A branched polyorganosiloxane expressed by the following formula:

   ((CH3)HSiO1/2)0.67(SiO4/2)0.33

   (viscosity: 25 mPa·s, amount of silicon atom-bonded hydrogen atoms: 0.96% by mass)
- Component (B-2): A linear dimethylsiloxane-methylhydrogensiloxane copolymer blocked at both molecular chain ends with trimethylsiloxy (viscosity: 9 mPa·s, amount of silicon atom-bonded hydrogen atoms: 0.75 mass%)
- Component (B-3): A linear dimethylpolysiloxane blocked at both molecular chain ends with dimethylhydrogensiloxy (viscosity: 14 mPa·s, amount of silicon atom-bonded hydrogen atoms: 0.15 mass%)
Note that each of the abovementioned components (B-1) to (B-3) has two or more hydrogen atoms bonded to silicon atoms in one molecule.

### Component (C)

### •Component (C-1): A trisiloxane expressed by the following formula (viscosity: 0.8 mPa s)

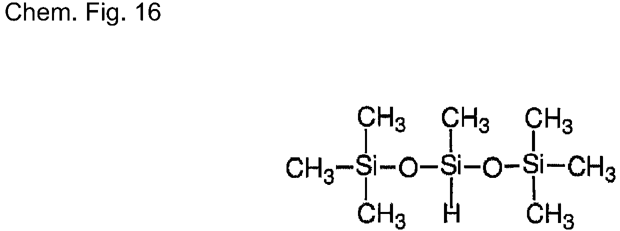

### Component (D)

### •Component (D-1): A complex of platinum and 1,3-divinyl-1,1,3,3-tetramethyldisiloxane (amount of platinum: 0.5 mass%)

### Component (E)

- Component (E-1): A cerium silanolate having an Si-O-Ce bond in a molecule (amount of cerium in silanolate: 0.5 mass%)
- Component (E-2): An iron(III) tris(2-ethylhexanoate) mineral spirit solution (amount of iron in solution: 6 mass%)

### Component (F)

### •Component (F-1): 1-ethynylcyclohexanol (ETCH)

### Component (G)

### •Component (G-1): 1,6-bis(trimethoxysilyl)hexane

### Component (H)

Component (H-1): Hydrogensiloxane having a trialkoxysilyl group, the hydrogensiloxane being expressed by the following formula (viscosity: 1.6 mPa s)

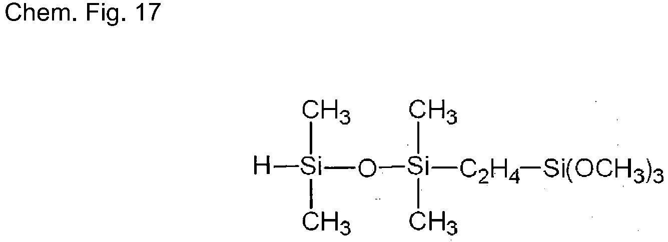

### 1/4 Cone Penetration of Silicone Gel

The silicone gel-forming composition was gently poured into a 50 mL glass beaker to a height of 3 cm from the bottom of the beaker, and then heated at 100°C for 30 minutes to produce a silicone gel. The 1/4 cone penetration of the silicone gel was measured by a method specified in JIS K2220. The 1/4 cone penetration of the silicone gel before being subjected to the heat resistance test described later was taken as the "initial penetration".

### Transparency of Silicone Gel

The cured silicone gel was visually observed from above the beaker, and if the bottom of the beaker was visible, the silicone gel was deemed to be transparent and to have passed.

### Heat Resistance of Silicone Gel

The silicone gel cured by the method above was placed in an oven at 225°C. Furthermore, after 1000 hours and 2000 hours, each sample was taken out and cooled to 25°C at room temperature. Thereafter, the 1/4 cone penetration of the silicone gel was measured by the method specified in JIS K2220. The 1/4 cone penetration after 1000 hours and 2000 hours was taken as the "penetration after 1000 hours" and the "penetration after 2000 hours", respectively, and a test piece with a change rate of the penetration after 2000 hours from the initial penetration within 50% was deemed to have passed.

**Table 1**

| | | | Units | Example 1 | Example 2 | Example 3 | Example 4 | Example 5 | Example 6 | Example 7 | Example 8 | Example 9 | Comparative Example 1 | Comparative Example 2 | Comparative Example 3 | Comparative Example 4 |
|---|---|---|---|---|---|---|---|---|---|---|---|---|---|---|---|---|
| | Component (A) | (A-1) | parts by mass | 100 | 100 | 100 | 100 | | | | 100 | 100 | 100 | 100 | 100 | |
| | | (A-2) | parts by mass | | | | | 100 | | | | | | | | 100 |
| | | (A-3) | parts by mass | | | | | | 100 | | | | | | | |
| | | (A-4) | parts by mass | | | | | | | 100 | | | | | | |
| Composition | Component (B) | (B-1) | parts by mass | 0.64 | | | | | | | | | 0.64 | | | |
| | | (B-2) | parts by mass | | 0.93 | 0.93 | 0.70 | 0.21 | | 0.45 | 0.93 | 0.93 | | 0.93 | 0.93 | 0.21 |
| | | (B-3) | parts by mass | 4.00 | | | 3.00 | 3.00 | 5.00 | | | | 4.00 | | | 3.00 |
| | Component (C) | (C-1) | parts by mass | 1.20 | 2.30 | 2.30 | 2.00 | 0.50 | 2.50 | 1.30 | 2.80 | 1.80 | | 2.30 | 1.00 | |
| | Component (D) | (D-1) | parts by mass | 0.20 | 0.20 | 0.20 | 0.20 | 0.20 | 0.20 | 0.20 | 0.20 | 0.20 | 0.28 | 0.20 | 0.20 | 0.20 |
| | Component (E) | (E-1) | parts by mass | 0.50 | 0.50 | | 0.50 | 0.50 | 0.50 | 0.50 | 0.50 | 0.50 | 0.50 | | 0.50 | 0.50 |
| | | (E-2) | parts by mass | | | 0.02 | | | | | | | £ | | | |
| | Component (F) | (F-1) | parts by mass | 0.02 | 0.02 | 0.02 | 0.02 | 0.02 | 0.02 | 0.02 | 0.02 | 0.02 | 0.02 | 0.02 | 0.02 | 0.02 |
| | Component (G) | (G-1) | parts by mass | | | | | | | | 0.3 | | | | | |
| | Component (H) | (H-1) | parts by mass | | | | | | | | | | | | | 0.5 |
| | HNi (component (B) / component (A)) | | | 0.75 | 0.43 | 0.43 | 0.60 | 0.82 | 0.44 | 0.36 | 0.43 | 0.43 | 0.75 | 0.43 | 0.43 | 0.82 |
| | H/Vi ((component (B) + (C)) /component (A)) | | | 1.08 | 1.06 | 1.06 | 1.15 | 1.12 | 1.10 | 1.00 | 1.20 | 0.93 | 0.75 | 1.06 | 0.70 | 1.06 |
| Properties | Viscosity | | mPa·s | 380 | 400 | 400 | 380 | 650 | 460 | 3000 | 380 | 400 | 380 | 390 | 390 | 660 |
| | Initial penetration | | 1/10m m | 55 | 58 | 54 | 61 | 62 | 70 | 40 | 59 | 62 | 52 | 58 | 60 | 59 |
| | Penetration after 1000 hours | | 1/10m m | 50 | 68 | 65 | 75 | 66 | 65 | 38 | 60 | 68 | 42 | < 1 | 40 | 40 |
| | Penetration after 2000 hours | | 1/10mm | 49 | 60 | 54 | 61 | 56 | 69 | 35 | 57 | 50 | 20 | < 1 | 10 | < 1 |
| Evaluation | Transparency | | - | Pass | Pass | Pass | Pass | Pass | Pass | Pass | Pass | Pass | Pass | Pass | Pass | Pass |
| | Heat resistance | | - | Pass | Pass | Pass | Pass | Pass | Pass | Pass | Pass | Pass | Fail | Fail | Fail | Fail |

As depicted in Table 1, the silicone gels of Examples 1 to 9, which contained all of components (A) to (E), exhibited little change in 1/4 cone penetration values even 2000 hours after exposure to a high-temperature environment compared to before exposure, demonstrating excellent heat resistance over an extended period of time and transparency.
On the other hand, in Comparative Example 1, which did not contain component (C), the 1/4 cone penetration value after 2000 hours was significantly smaller than before exposure, indicating that sufficient heat resistance was not provided.
Furthermore, in Comparative Example 2, which did not contain component (E), the 1/4 cone penetration value even after 1000 hours was significantly smaller than before exposure, indicating that sufficient heat resistance was not provided.
Furthermore, in Comparative Example 3, in which the molar ratio of silicon atom-bonded hydrogen atoms in components (B) and (C) to alkenyl groups in component (A) was less than 0.80, the 1/4 cone penetration value after 2000 hours was significantly smaller than before exposure, indicating sufficient heat resistance was not provided.
Furthermore, in Comparative Example 4, which contained a hydrogensiloxane having a trialkoxysilyl group (component (H)), the 1/4 cone penetration value after 2000 hours was significantly smaller than before exposure, indicating that sufficient heat resistance was not provided.

## Claims

1. A silicone gel-forming composition, comprising the following components (A) to (E):
(A) an organopolysiloxane having, on average, two or more alkenyl groups bonded to a silicon atom in one molecule;
(B) an organohydrogenpolysiloxane having two or more hydrogen atoms bonded to silicon atoms in one molecule;
(C) an organosiloxane compound having one hydrogen atom bonded to a silicon atom in one molecule (excluding compounds having an alkoxysilyl group);
(D) a hydrosilylation reaction catalyst; and
(E) a heat-resistant additive, wherein
the molar ratio of silicon atom-bonded hydrogen atoms in components (B) and (C) to alkenyl groups in component (A) is 0.80 or greater.

2. The silicone gel-forming composition according to claim 1, wherein the molar ratio of silicon atom-bonded hydrogen atoms in component (B) to alkenyl groups in component (A) is 0.10 or greater.

3. The silicone gel-forming composition according to claim 1, wherein component (C) contains at least one selected from the group consisting of compounds expressed by the following general formulas (1) to (7). 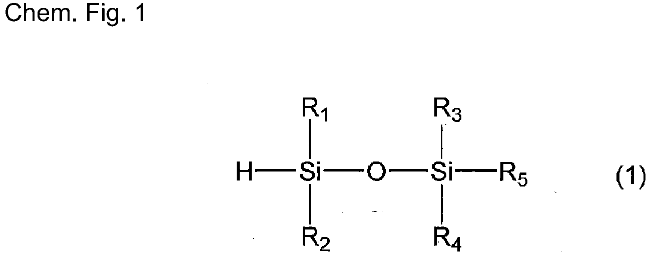 (In formula (1), R₁ to R₅ are each independently the same or different monovalent hydrocarbon groups with 1 to 12 carbon atoms and no aliphatic unsaturated bonds.) 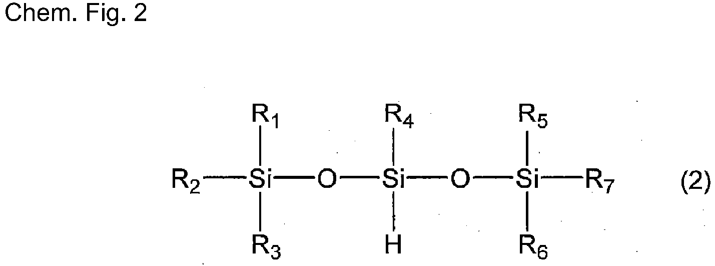 (In formula (2), R₁ to R₃ and R₅ to R₇ are each independently the same or different monovalent hydrocarbon groups with 1 to 12 carbon atoms and no aliphatic unsaturated bonds, and R₄ is a group selected from: monovalent hydrocarbon groups with 1 to 12 carbon atoms and no aliphatic unsaturated bonds; and trimethylsiloxy groups.) 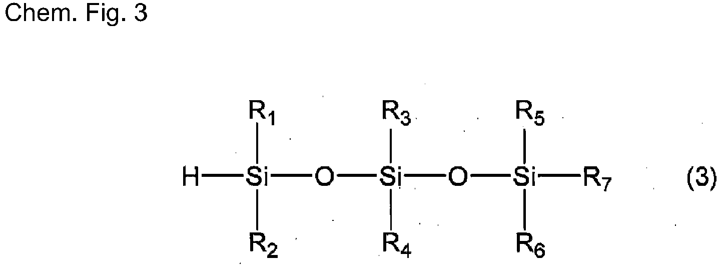 (In formula (3), R₁, R₂, and R₅ to R₇ are each independently the same or different monovalent hydrocarbon groups with 1 to 12 carbon atoms and no aliphatic unsaturated bonds, and R₃ and R₄ are each independently a group selected from the group consisting of the same or different monovalent hydrocarbon groups with 1 to 12 carbon atoms and no aliphatic unsaturated bonds; and trimethylsiloxy groups.) 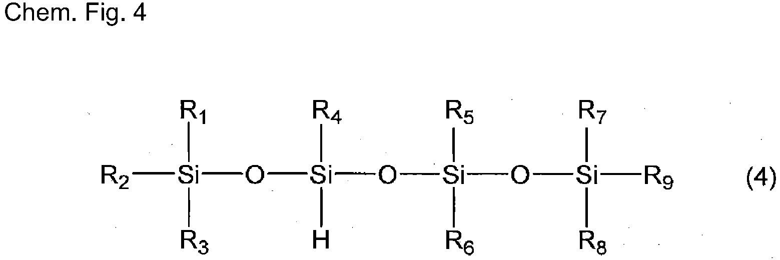 (In formula (4), R₁ to R₃ and R₇ to R₉ are each independently the same or different monovalent hydrocarbon groups with 1 to 12 carbon atoms and no aliphatic unsaturated bonds, and R₄ to R₆ are each independently a group selected from the group consisting of the same or different monovalent hydrocarbon groups with 1 to 12 carbon atoms and no aliphatic unsaturated bonds; and trimethylsiloxy groups.) 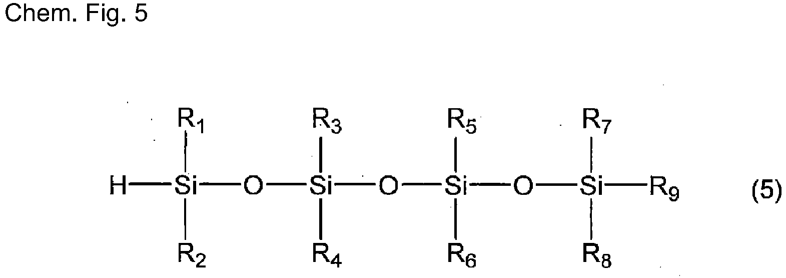 (In formula (5), R₁, R₂, and R₇ to R₉ are each independently the same or different monovalent hydrocarbon groups with 1 to 12 carbon atoms and no aliphatic unsaturated bonds, and R₃ to R₆ are each independently a group selected from the group consisting of the same or different monovalent hydrocarbon groups with 1 to 12 carbon atoms and no aliphatic unsaturated bonds; and trimethylsiloxy groups.) 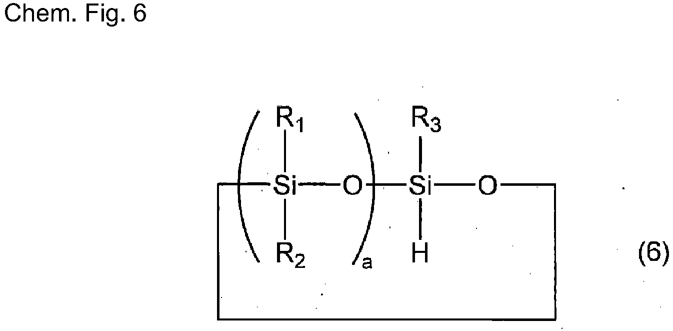 (In formula (6), R₁ and R₂ are each independently the same or different monovalent hydrocarbon groups with 1 to 12 carbon atoms and no aliphatic unsaturated bonds, and R₃ is a group selected from: the same or different monovalent hydrocarbon groups with 1 to 12 carbon atoms and no aliphatic unsaturated bonds; and trimethylsiloxy groups. a is an integer of 2 to 5.) 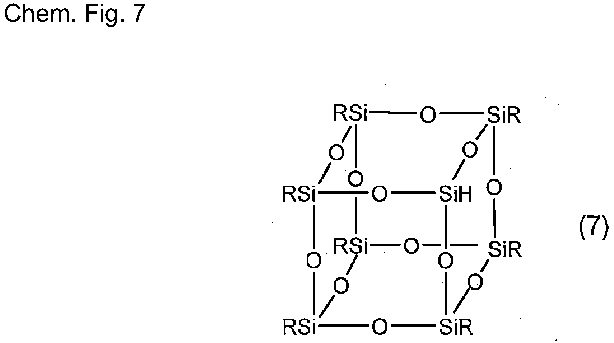 (In formula (7), each R is independently the same or different monovalent hydrocarbon group with 1 to 12 carbon atoms and no aliphatic unsaturated bonds.)

4. The silicone gel-forming composition according to claim 1, wherein the viscosity of component (A) at 25°C is 10 to 10,000 mPa·s, and
the viscosity of component (B) at 25°C is 2 to 1,000 mPa·s.

5. The silicone gel-forming composition according to claim 1, wherein component (A) is at least one selected from the group consisting of linear organopolysiloxanes, branched organopolysiloxanes, and mixtures thereof.

6. The silicone gel-forming composition according to claim 1, wherein the amount of component (D) is 0.01 to 1,000 ppm by mass based on the total amount of the silicone gel-forming composition.

7. The silicone gel-forming composition according to claim 1, wherein component (E) contains at least one selected from the group consisting of metal silanolates and metal carboxylates.

8. The silicone gel-forming composition according to claim 7, wherein the metal is selected from the group consisting of cerium, iron, manganese, vanadium, magnesium, aluminum, nickel, titanium, and zinc.

9. The silicone gel-forming composition according to claim 1, which is substantially transparent.

10. The silicone gel-forming composition according to claim 1, for use in sealing an electronic component.

11. The silicone gel-forming composition according to claim 10, wherein the electronic component is a power device.

12. An electronic component sealant, comprising the silicone gel-forming composition according to claim 1.

13. The electronic component sealant according to claim 12, which is substantially transparent.

14. A silicone gel obtained by curing the silicone gel-forming composition according to any one of claims 1 to 11 or the electronic component sealant according to claim 12 or 13.

15. The silicone gel according to claim 14, wherein the 1/4 cone penetration value as specified in JIS K2210 is 10 to 150.

16. An electronic component, comprising the silicone gel according to claim 14.

17. A method for manufacturing an electronic component, the method comprising a step for using the silicone gel-forming composition according to any one of claims 1 to 11 or the electronic component sealant according to claim 12 or 13.
